# EUROPEAN PATENT APPLICATION

(11) **EP 0 961 435 A2**
(43) Date of publication of application: **01.12.1999**
(21) Application number: 99108473.2
(22) Date of filing: 30.04.1999
(51) Int. Cl.: H04J 3/16

(54) **Method and apparatus for accessing a parallel memory buffer with serial data**

(30) Priority: 26.05.1998 US 85146
(71) Applicant: Siemens Information and Communication Networks Inc., Boca Raton, FL 33487 (US)
(72) Inventor: Cole, Steven R., San Jose, CA 95117-3618 (US)
(74) Representative: Allen, Derek

(57) **Abstract**

A memory buffer apparatus (29) includes an extended shift register (32) and a memory (30). The extended shift register (32) shifts a plurality of serial bits to produce a multi-bit data word. The multi-bit data word has a predetermined length based on a delay interval that is a multiple of a serial bit period. The memory (30) stores the bit-slice of the multi-bit data word. The bit-slice has a length less than that of the multi-bit data word. An extended output shift register (34) can also be included in the apparatus (29). The extended output shift register (34) has a length greater than the stored bit-slice, and performs a parallel-to-serial conversion of the bit-slice output from the memory (30).

## Description

### BACKGROUND OF THE INVENTION

The present invention relates generally to time-division multiplexed (TDM) communication systems, and in particular, to a method and apparatus for accessing a parallel memory buffer with serial data.

### DESCRIPTION OF THE RELATED ART

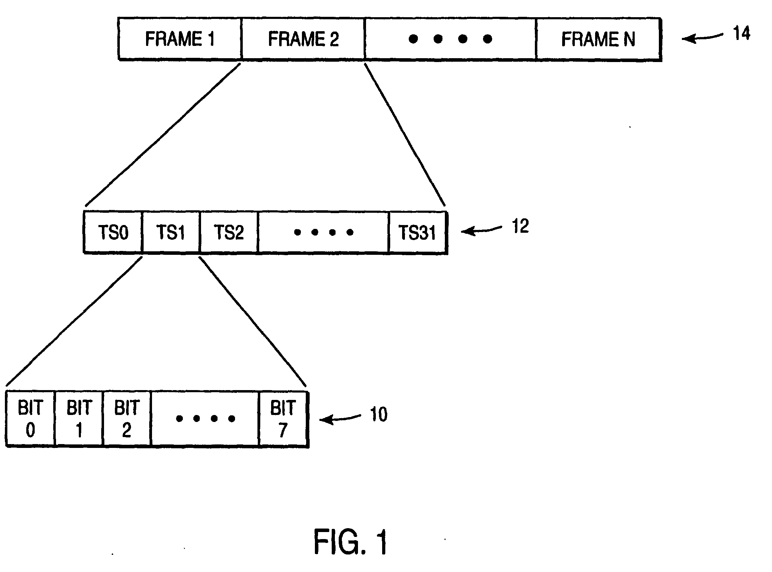

In a time-division multiplexed (TDM) system, data is transported in serial data streams. Each element of data, typically a bit, occupies a predefined period of time in the data stream. FIG. 1 illustrates a conceptual diagram of how serial data can be organized in a bit stream in a typical TDM system. This example depicts the data organization used in a standard T1/E1 telecommunication serial bit stream. Serial bits 10 are grouped into units called timeslots 12. Each timeslot includes a sequence of eight bits. Timeslots are grouped into units called frames 14. As shown, a T1/E1 frame includes 32 timeslots (256 bits) of data. In conformity with industry standards, data in T1/EI frames are generally pulse code modulated (PCM).

TDM systems are used in various telecommunication systems, such as a Siemens Private Branch Exchange (PBX) for transporting serial data. In such systems, the serial data is sometimes used for accessing a buffer memory. In order to access the buffer memory, the serial data is converted to parallel format. The parallel data from the buffer memory is then converted to serial format and then transported serially in the system.

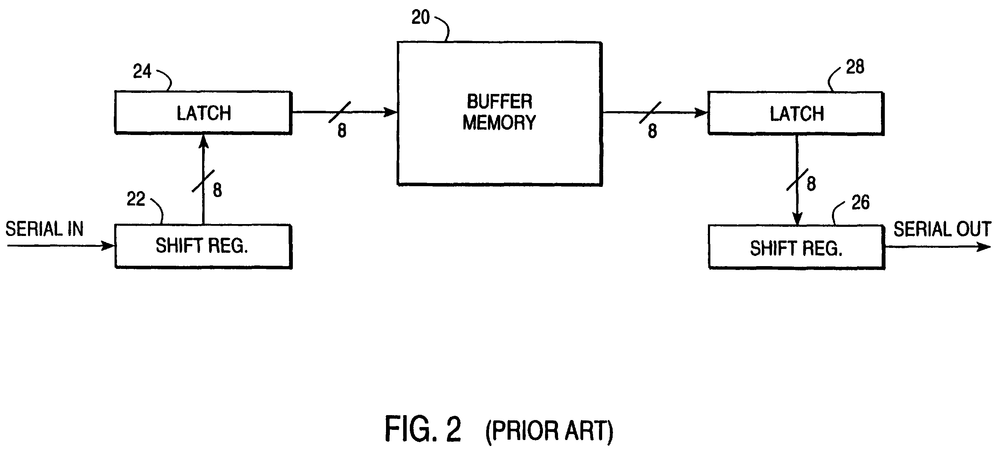

FIG. 2 illustrates a prior art apparatus for buffering serial data. The apparatus includes a memory 20, an input shift register 22, an input latch 24, an output shift register 26, and an output latch 28. Serial data is received by the input shift register 22, which performs a serial-to-parallel conversion. The eight bit output of the shift register 22 is temporarily stored in the latch 24. The latch 24 is necessary because storing the parallel data in the memory 20 frequently requires more time than the duration of a single serial input bit. In an application as discussed above, the timeslot data is used as an address to look up data in the buffer memory. The data from the buffer memory 20 is latched by an output latch 28 and converted to serial data by way of a parallel to serial shift register and subsequently transported in the system. There are other applications in a telecommunication system where buffer accesses are required by a serial bit stream. Unfortunately, such an implementation, such as that shown in FIG. 2, requires an equivalent of 32 flip-flops, which increases the complexity and cost of this system.

### SUMMARY OF THE INVENTION

Briefly, the present invention relates to a system for accessing a parallel buffer in a TDM system with a serial data which utilizes fewer components than known systems. In order to reduce the number of components, the system includes extended shift registers selected to have bit lengths greater than each time slot in the TDM telecommunications data. By proper selection of the shift register length, buffer access registers are possible in such TDM systems using relatively fewer components than known systems.

### BRIEF DESCRIPTION OF THE DRAWING

Other features, objects and advantages of the present invention will become readily apparent and understood upon consideration of the following detailed description and attached drawings, wherein:
FIG. 1 illustrates a conceptual diagram of T1 carrier serial data;
FIG. 2 illustrates a block diagram of a prior art circuit for buffering serial data;
FIG. 3 illustrates a block diagram of an apparatus for buffering TDM data in accordance with one embodiment of the present invention; and
FIG. 4 illustrates a block diagram of an apparatus for buffering multiple channels of TDM data in accordance with another embodiment of the present invention.

### DETAILED DESCRIPTION OF THE INVENTION

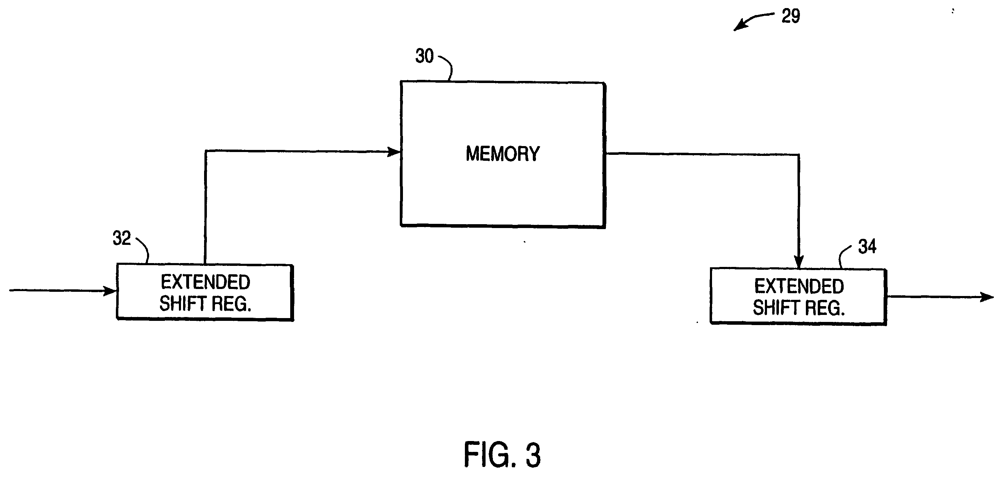

Turning now to the drawings, and in particular to FIG. 3, there is illustrated a block diagram of an apparatus 29 for buffering TDM data in accordance with one embodiment of the present invention, The memory buffer apparatus 29 includes an extended input shift register 32 and an extended output shift register 34 for accessing a parallel buffer memory 30. Serial data is input to the apparatus 29 and, in particular, to the extended input shift register 32, formatted as shown in FIG. 1. When receiving data in this format, the apparatus 29 is particularly useful for storing a time slot of data (eight bits) in the memory 30 at a predetermined time occurring during a subsequent time slot.

The extended shift input register 32 performs a serial-to-parallel conversion by shifting a plurality of serial input bits to produce a multi-bit data word. The multi-bit data word has a predetermined length based on a delay interval that is a multiple of the period of a serial bit. The delay interval can extend less than the period of one timeslot. In the example shown, the extended shift register 32 includes twelve registers, whereby a multi-bit word having a length of twelve bits may be generated. The incoming bits are shifted from the least significant bit of the register 32 (bit 0) toward the most significant bit (bit 7) of each timeslot. The bits are shifted once during every bit period.

The eight shifted bits of the previous timeslot are available at the last eight taps of the shift register during the fourth bit period of the following timeslot. During the fourth period, the input access to the memory 30 is performed.

During a buffer access operation, the memory contents are provided to the extended output shift register 34 at the lower eight bits of the register 34. The contents of the shift register 34 are then shifted once during each bit period toward the most significant bit (bit 11) of the register 39. The memory data is loaded into the lower 8-bits of the shift register during the fifth bit of the previous timeslot. This permits data to be serially output from the register 39 during the subsequent timeslot, consistent with the TDM protocol.

It is noted that in alternate embodiments, different sized input and output extended shift registers input and output may be employed. Thus, for example, 9-bit shift registers may be used. In such a case, the extended shift register 32 again receives incoming bits again shifting from least to most significant bit. The eight bits of the previous timeslot are available during the first bit period of the following timeslot, and the input access to memory is performed. Similarly, memory data is loaded into the lower eight bits of the output shift register 34 during the last bit period of the previous timeslot.

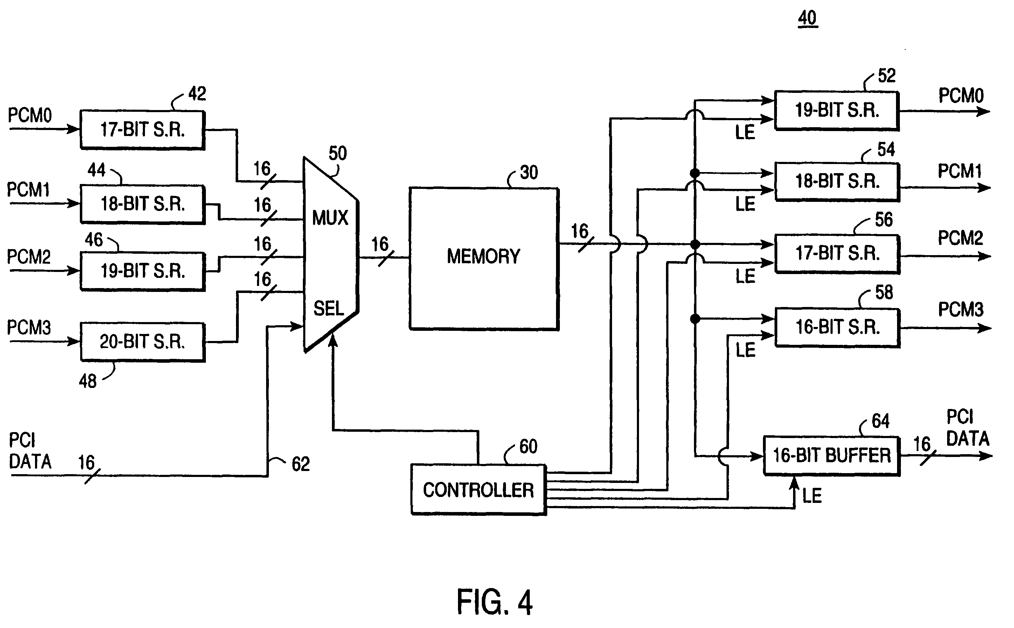

FIG. 4 illustrates a block diagram of apparatus for buffering multiple channels of TDM data in accordance with another embodiment of the present invention. The apparatus 40 provides a buffer interface of serial data of a TDM system and parallel data from a computer system by way of a peripheral component interface (PCI) and can be used as a B-channel access device (BCAD) which forms part of a PBX system. The apparatus 40 includes a plurality of input shift registers 42-48, a multiplexer (MUX) 50, a plurality of output shift registers 52-58, a controller 60, a parallel input port 62 and a parallel output buffer 64. Each serial data stream represents a PCM data highway transmitting serial data transformed in accordance with the format of FIG. 1. Serial data on each highway is simultaneously received by the input shift registers 42-48. Each of the input shift registers 42-48 performs a serial to parallel conversion of incoming PCM data, which is then applied to the memory 30 under the control of the controller 60. In this example, the memory 30 is partitioned into a plurality of buffers for storing 16-bit data words corresponding to each PCM channel. The apparatus 40 may be used to provide continuous data flow between the PCI and PCM channels.

The parallel data from the memory is transferred to the output shift registers 52-58 and a 16-bit buffer 64. The output shift registers convert the parallel data from the memory to serial data. The 16-bit buffer 64 is used for buffering 16-bit PCI data.

Since the PCM interface must operate at a constant rate, accesses to the memory 30 are synchronized to the PCM interface. For every data frame, a frame's worth of data (32 bytes) must be moved between the PCM and PCI interfaces in each direction. To facilitate this, parallel data is transported to the memory 30 as 16-bit words.

Each of the input shift registers 42-48 receives a respective serial data stream. The serial data streams can represent PCM data highways, each transporting serial data formatted in accordance with the format shown in FIG. 1. Serial data on each highway is simultaneously received by the input shift registers 42-48. Each of the input shift registers 42-48 performs a serial to parallel conversion of incoming PCM data, allowing the PCM data to be stored in the memory 30.

The input shift registers 42-48 all have different lengths. As shown in the example, the PCM0 shift register 42 has a length of 17-bits, the PCM1 shift register 44 has a length of 18-bits, the PCM2 shift register 46 has a length of 19-bits, and the PCM3 shift register 48 has a length of 20-bits. Sixteen-bit output words are read from each of the registers 42-48 in sequential order, starting with the PCM0 register 42 and continuing through to the PCM3 register 48. The registers 42-48 are accessed at the PCM data bit rate, each being accessed during a respective bit period. The varying lengths of the shift registers 42-48 permit the incoming serial data to be property aligned for being written into the memory 30. This prevents any incoming data from being lost and precludes the need for extra latches at the output of each register.

To provide continuous data flow, eight PCM channel operations must be performed within every two timeslot periods. Four memory write operations are performed, one for each of the PCM inputs, and four memory read operations are performed corresponding to each of the outgoing PCM channels. In this example, the memory 30 stores 16-bit data words.

The output shift registers perform a parallel-to-serial conversion of data read from the memory 30 and have different lengths, similar to the input shift registers 42-48. The serial output of each output shift registers 52-58 is provided to a respective PCM data highway. The buffer 64 is used for buffering PCI data. The inclusion of shift registers having different lengths eliminates the need to provide shift register/latch pairs of each PCM channel. This greatly reduces the number of components in the apparatus 40.

The controller 60 controls the memory accesses by strobing the select signal (SEL) to the multiplexer 50 and the load enable signals (LE) of the output shift registers 52-58 and the parallel output buffer 64. During each bit period of the TDM timeslots, the controller 60 can perform one of three functions. The controller 60 (1) selects a data input from one of the input shift registers 42-48 to be written into the memory 30, (2) selects one of the output shift registers 52-58 to receive a memory output value, or (3) allows a read or write access to the PCI between PCM operations.

## Claims

1. An apparatus for buffering a serial data stream in a time-division multiplexed (TDM) system, comprising:
means for shifting a plurality of serial bits to produce a multi-bit data word having a predetermined length based on a delay interval that is a multiple of a serial bit period; and
means for storing a predetermined bit-slice of the multi-bit data word having a length less than that of the multi-bit data word.

2. The apparatus of claim 1, further comprising:
means for receiving the predetermined bit-slice from the storing means; and
means for shifting the predetermined bit-slice to produce an output serial data stream.

3. The apparatus of claim 2, wherein the means for shifting the predetermined bit-slice has a length based on the delay interval.

4. The apparatus of claim 2, wherein the means for shifting the predetermined bit-slice has a length based on a second delay interval that is a second multiple of a serial bit period.

5. An apparatus for buffering a plurality of serial data streams in a time-division multiplexed (TDM) system, comprising:
a plurality of shift registers responsive to the plurality of serial data streams, each of the shift registers having a different length and being responsive to a corresponding one of the serial data streams;
a memory for storing a plurality of multi-bit data words;
a multiplexer for providing a plurality of predetermined bit-slices from the shift registers to the memory; and
a controller causing the multiplexer to select each of the shift registers in a predetermined order.

6. The apparatus of claim 5, further comprising:
a parallel input port in communication with the multiplexer.

7. The apparatus of claim 5, further comprising:
a plurality of output shift registers responsive to the memory.

8. The apparatus of claim 7, wherein each of the output shift registers has a different length.

9. The apparatus of claim 7, wherein the controller provides a load enable to each of the output shift registers.

10. The apparatus of claim 9, wherein the controller provides the load enable signal to each to the output shift registers in a predetermined order.

11. The apparatus of claim 5, further comprising:
a parallel output port in communication with the memory.

12. The apparatus of claim 11, wherein the controller provides a load enable signal to the parallel output port.

13. A method of buffering a serial data stream in a time-division multiplexed (TDM) system, comprising:
providing a shift register having a predetermined length based on a delay interval that is a multiple of a serial bit period;
shifting the serial data stream into the shift register to produce a multi-bit data word equivalent to the predetermined length; and
storing a bit-slice of the multi-bit data word having a length less than that of the multi-bit data word.
